# EUROPEAN PATENT APPLICATION

(11) **EP 4 628 928 A1**
(43) Date of publication of application: **08.10.2025**
(21) Application number: 25168107.8
(22) Date of filing: 02.04.2025
(51) Int. Cl.: G01S 7/481, G02B 6/12, H01L 25/16

(54) **OPTICAL CHIP PACKAGING MODULE, OPTICAL MODULE, AND LIDAR**

(30) Priority: 07.04.2024 CN 202410414484
(71) Applicant: Suteng Innovation Technology Co., Ltd., Shenzhen City Guangdong 518000 (CN)
(72) Inventor: CAO, Rentian, Shenzhen City (CN); LI, Yanmin, Shenzhen City (CN)
(74) Representative: Ran, Handong

(57) **Abstract**

An optical chip packaging module, an optical module, and a LiDAR are provided. The optical chip packaging module includes a carrier board and a light-transmitting cover plate covering the carrier board, forming a hermetic space between the carrier board and the light-transmitting cover plate. Within the hermetic space, an optical chip is fixed on the carrier board. The carrier board includes a thermally conductive material in contact with the optical chip, wherein the thermally conductive material includes ceramic material and/or metal material.

## Description

### TECHNICAL FIELD

The present application relates to the field of packaging technology, and more specifically, to an optical chip packaging module, an optical module, and a LiDAR.

### BACKGROUND

In autonomous driving and intelligent sensing fields, LiDAR is a critical component. Its working principle involves emitting laser beams to detect targets, receiving reflected laser beams, and processing the information to obtain parameters such as target distance, orientation, and speed. A LiDAR includes an emitter, receiver, and signal processing unit. In the emitter's packaging, heat dissipation must be addressed due to significant heat generated by its components.

### SUMMARY

Embodiments of the present application provide an optical chip packaging module, an optical module, and a LiDAR, which enable rapid heat dissipation and ensure yield.

Embodiments of the present application provide an optical chip packaging module, comprising a carrier board and a light-transmitting cover plate mounted on the carrier board, where a hermetic space is formed between the carrier board and the light-transmitting cover plate; an optical chip is fixed on the carrier board in the hermetic space, where the carrier board includes a thermally conductive material in contact with the optical chip, and the thermally conductive material includes ceramic material and/or metal material.

In some embodiments, the carrier board includes a substrate; the thermally conductive material is fixed on a surface of the substrate; or the thermally conductive material is embedded within the substrate.

In some embodiments, the thermally conductive material is bonded to the surface of the substrate via a resin adhesive, or the thermally conductive material is embedded within the substrate via a resin adhesive; or the thermally conductive material is embedded within the substrate via a soldering process.

In some embodiments, the substrate is provided with a through-hole in a region corresponding to the optical chip, and the shape of the thermally conductive material matches the shape of the through-hole for embedding into the through-hole; or the thermally conductive material includes a first portion with a shape matching the shape of the through-hole for embedding into the through-hole, and a second portion extending from one end of the first portion along the surface of the substrate, where the second portion abuts a side of the substrate opposite to the optical chip.

In some embodiments, the thermally conductive material includes at least two thermally conductive metal columns; where the at least two thermally conductive metal columns are prefabricated on the substrate at a region connected to at least one group of vertical-cavity surface-emitting lasers through a via process, and penetrate through the substrate.

In some embodiments, the carrier board includes at least one layer of stacked aluminum nitride ceramic substrates.

In some embodiments, each layer of the ceramic substrate is embedded with at least one metal column.

In some embodiments, the at least one metal column includes an inverted trapezoidal-shaped metal column; and/or the at least one metal column includes a copper column or a tungsten column.

In some embodiments, the light-transmitting cover plate includes a metal cover fixed to the carrier board and a light-transmitting component for transmitting laser beams, where the light-transmitting component is bonded to the metal cover via a sealing adhesive; the metal cover is bonded to the carrier board via a sealing adhesive; or the substrate is provided with a tin ring, and the metal cover is fixed to the carrier board by welding to the tin ring.

In some embodiments, UV adhesive is coated around the optical chip on the carrier board, and the light-transmitting cover plate is cured and adhered to the UV adhesive, and the light-transmitting cover plate, the UV adhesive, and the carrier board collectively form the hermetic space; at least a portion of the carrier board outside the hermetic space is provided with a plastic encapsulation material to reinforce the optical chip packaging module.

In some embodiments, the carrier board is further fixed with a barrier structure, where the light-transmitting cover plate, the barrier structure, and the carrier board collectively form the hermetic space; the light-transmitting cover plate is sealed and bonded to the barrier structure.

Embodiments of the present application provide an optical module, comprising the optical chip packaging module described above and a circuit board; where the circuit board is provided with a power supply and an energy storage circuit, and the circuit board is electrically connected to the optical chip packaging module.

Embodiments of the present application provide a LiDAR, comprising the optical chip packaging module described above.

In the embodiments of the present application, the component generating the highest heat on the carrier board is the optical chip. By arranging the thermally conductive material (ceramic and/or metal) in contact with the optical chip on the carrier board, heat generated by the component with the highest heat generation can be rapidly dissipated, achieving rapid cooling and ensuring the yield of the optical chip packaging module.

### BRIEF DESCRIPTION OF DRAWINGS

FIG. 1 is a schematic diagram of the optical chip packaging module in an embodiment of the present application;
FIG. 2 is a schematic diagram of the optical chip packaging module in an embodiment of the present application;
FIG. 3 is a schematic diagram of the optical chip packaging module in an embodiment of the present application;
FIG. 4 is a schematic diagram of the optical chip packaging module in an embodiment of the present application;
FIG. 5 is a schematic diagram of the optical chip packaging module in an embodiment of the present application;
FIG. 6 is a schematic diagram of a logical structure of the receiving module in an embodiment of the present application;
FIG. 7 is a schematic diagram of a logical structure of the emitting module in an embodiment of the present application;
FIG. 8 is a schematic diagram of a circuit topology of the emitting module in an embodiment of the present application;
FIG. 9 is a schematic diagram of a circuit topology of the emitting packaging module in an embodiment of the present application;
FIG. 10 is a schematic diagram of an arrangement of at least some components in the emitting packaging module in an embodiment of the present application;
FIG. 11 is a schematic diagram of an arrangement of at least some components in the emitting packaging module in an embodiment of the present application; and
FIG. 12 is a schematic diagram of the LiDAR in an embodiment of the present application.

### DETAILED DESCRIPTION

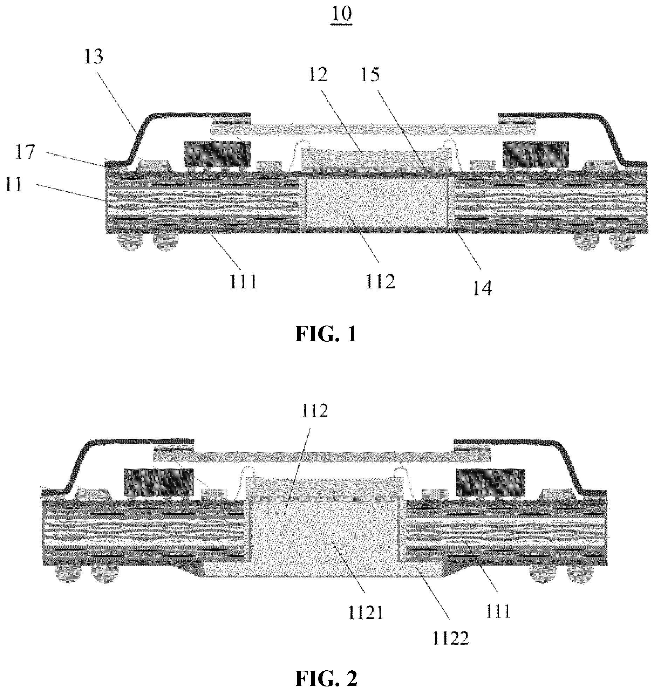

As shown in FIG. 1, which is a schematic diagram of the optical chip packaging module 10 in an embodiment of present application, the optical chip packaging module 10 includes a carrier board 11, an optical chip 12, and a light-transmitting cover plate 13. The light-transmitting cover plate 13 is fixed on the carrier board 11, forming a hermetic space with the carrier board 11. The optical chip 12 is fixed on the carrier board 11 within the hermetic space. In some embodiments, the optical chip 12 may be fixed to the carrier board 11 through various methods, such as adhesion using bonding materials (e.g., silver paste, conductive adhesive, non-conductive adhesive, or film), or fixation via ball bonding or sintering.

At least a portion of the light-transmitting cover plate 13 serves as a light-transmitting area for transmitting laser beams. In an embodiment, the optical chip 12 emits laser beams that exit through the light-transmitting area of the light-transmitting cover plate 13. In some embodiments, the optical chip 12 may function as a photodetector to receive laser beams entering through the light-transmitting area. In some embodiments, the hermetic space is filled with inert gas. The portion of the carrier board 11 in contact with the optical chip 12 is made of a thermally conductive material (e.g., ceramic or metal) to rapidly dissipate heat. In an embodiment, the ceramic material may include metallized ceramic blocks, while the metal material may include Kovar alloy, copper, or tungsten.

The thermally conductive material may be arranged in various configurations. In some embodiments, the carrier board includes a substrate, and the thermally conductive material is fixed on the substrate surface. For instance, the thermally conductive material is adhered to the substrate surface via resin adhesive, and the optical chip is fixed on the side of the thermally conductive material opposite to the substrate. In some embodiments, the thermally conductive material is embedded within the substrate. In an embodiment, as shown in FIG. 1, the carrier board 11 includes a substrate 111 with a through-hole, and the thermally conductive material 112 is embedded within the through-hole via adhesive 14. The optical chip 12 is bonded to the thermally conductive material 112 using conductive silver paste 15. The substrate 111 may be composed of Bismaleimide Triazine (BT) resin, a lead frame, or ceramic.

In some embodiments, the shape and volume of the thermally conductive material 112 may not fully match those of the through-hole. In an embodiment, as shown in FIG. 2, which is a schematic diagram of the optical chip packaging module, the thermally conductive material 112 includes a first portion 1121 that matches the shape of the through-hole for embedding into the through-hole. The thermally conductive material 112 further includes a second portion 1122 extending from one end of the first portion 1121 along the surface of the substrate 111. The second portion 1122 abuts a side of the substrate 111 opposite to the optical chip 12.

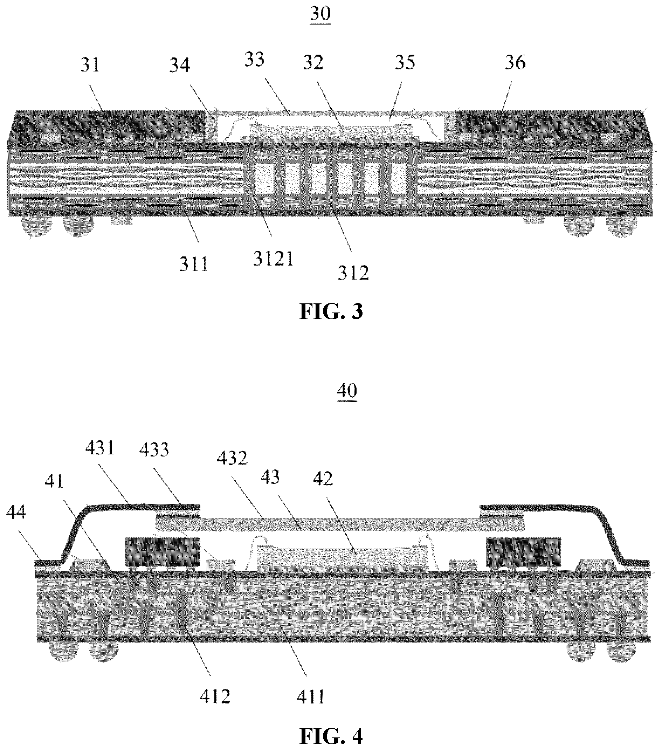

The thermally conductive material may be a monolithic block as shown in FIG. 1, or In some embodiments, as shown in FIG. 3 (a schematic diagram of another embodiment of the optical chip packaging module), the optical chip packaging module 30 includes a carrier board 31, an optical chip 32, and a light-transmitting cover plate 33. The carrier board 31 includes a substrate 311 and a thermally conductive material 312 that includes at least two thermally conductive metal columns 3121 penetrating through the substrate 311. In some embodiments, the at least two thermally conductive metal columns 3121 are prefabricated through a via process in regions of the substrate connected to the optical chip 32. The thermally conductive metal columns 3121 may be copper columns or tungsten columns.

In some embodiments, the carrier board includes at least one layer of stacked aluminum nitride (AlN) ceramic substrates, with the optical chip mounted on the ceramic substrates. The AlN ceramic substrates themselves act as thermally conductive materials to dissipate heat from the optical chip. AlN ceramic substrates exhibit high thermal conductivity, significantly enhancing the overall heat dissipation of the module. As shown in FIG. 4, the optical chip packaging module 40 includes a carrier board 41, an optical chip 42, and a light-transmitting cover plate 43. The carrier board 41 is formed by stacking and bonding at least one layer of AlN ceramic substrates 411. Each ceramic substrate 411 is embedded with at least one metal column 412 to improve thermal conduction between the stacked layers. The metal columns 412 may include inverted trapezoidal-shaped columns, copper columns, or tungsten columns. The positions and quantities of the embedded metal columns 412 may vary across different ceramic substrate layers.

In the embodiments of the present application, the device with the largest heat generation on the carrier board is the optical chip. By arranging a thermally conductive material in contact with the optical chip on the carrier board, the thermally conductive material includes a ceramic material and/or a metal material, so that the heat generated by the device with the largest heat generation on the carrier board can be quickly conducted away, thereby achieving a rapid cooling effect and ensuring the yield of the optical chip packaging module.

In the embodiments of the present application, the light-transmitting cover plate can be configured in multiple ways. In an embodiment, as shown in FIG. 4, the light-transmitting cover plate 43 includes a metal cover 431 fixed to the carrier board 41 and a light-transmitting component 432 for transmitting laser beams. In some embodiments, the metal cover 431 is made of Kovar alloy. The light-transmitting component 432 may be ordinary glass, coated glass, specialty glass, or transparent plastic. In some embodiments, the light-transmitting component 432 is adhered to the metal cover 431 via sealing adhesive 433 and fixed above the optical chip 42. The thermal expansion coefficients of the metal cover 431 and the carrier board 41 both fall within the range of [8×10⁻⁶/deg 12×10⁻⁶/deg], ensuring minimal thermal mismatch between the materials to prevent delamination of the optical chip packaging module. In some embodiments, the metal cover 431 is adhered to the carrier board 41 via sealing adhesive. In some embodiments, a tin ring 44 is installed on the substrate of the carrier board 11, and the metal cover 431 is welded and sealed to the carrier board 41 via the tin ring 44.

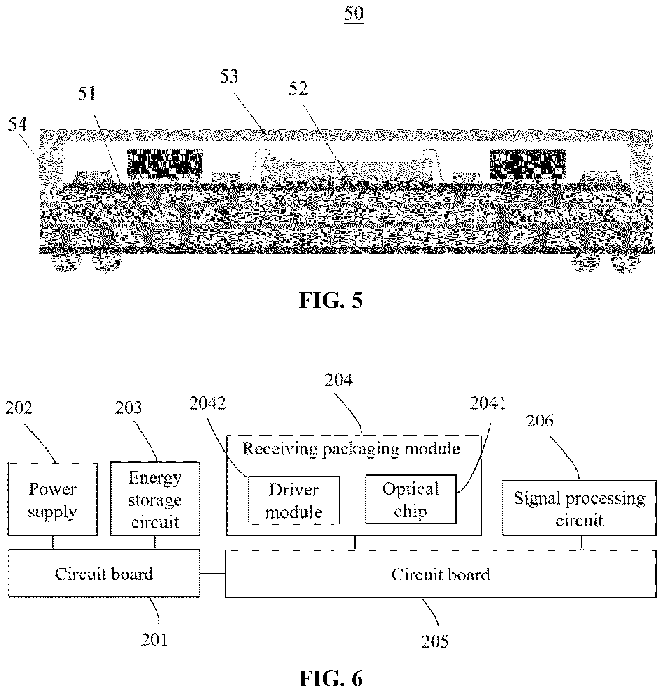

In some embodiments, the carrier board may include a barrier structure, and the light-transmitting cover plate may omit the metal cover, with the light-transmitting component directly fixed to the barrier structure. As shown in FIG. 5, the optical chip packaging module 50 includes a carrier board 51, an optical chip 52, and a light-transmitting cover plate 53. Unlike the embodiment in FIG. 4, the carrier board 51 is equipped with a barrier structure 54 surrounding the optical chip 52. The light-transmitting cover plate 53, functioning solely as a light-transmitting component, is adhered to the barrier structure 54. Together, the light-transmitting cover plate 53, barrier structure 54, and carrier board 51 form a hermetic space. The barrier structure 54 may be made of metal, ceramic, plastic, or a combination thereof (e.g., metal-plastic composites), and can be fabricated via resin bonding, injection molding, or adhesive dispensing to reduce costs and process complexity. The barrier structure 54 may be fixed to the carrier board 51 through various methods, such as adhesion using DAF film or metal welding, with no restrictions on the fixation method.

In some embodiments, the barrier structure 54 may enclose the optical chip 52 and other components within the hermetic space for protection. In some embodiments, the barrier structure 54 may isolate the optical chip 52 from other components on the carrier board 51. During the packaging process, the barrier structure is first fabricated and then serves as a protective boundary for subsequent steps. This eliminates the need for specialized optical chip protection during plastic encapsulation or custom-shaped molding cavities, thereby reducing process steps, enhancing mold compatibility, and lowering material, tooling, and production costs. The barrier structure ensures that no damage is introduced to the optical chip during encapsulation. Additionally, since no transparent medium covers the optical chip, packaging costs are further reduced. In some embodiments, the cavity containing the optical chip is encapsulated with plastic material to enhance sealing and mechanical strength. The thermal expansion coefficients of the barrier structure and the carrier board both fall within [8×10⁻⁶/deg, 12×10⁻⁶/deg], minimizing thermal mismatch and preventing delamination.

In an embodiment, as shown in FIG. 3, UV adhesive 34 is coated around the optical chip 32 on the carrier board 31, and the light-transmitting cover plate 33 is cured and adhered to the UV adhesive 34. The light-transmitting cover plate 33, UV adhesive 34, and carrier board 31 collectively form a hermetic space 35. It is understood that the aforementioned configurations of the light-transmitting cover plate may be combined with different arrangements of the thermally conductive material, without limitation.

In some embodiments, a plastic encapsulation material is disposed on at least part of the carrier board outside the hermetic space to reinforce the optical chip packaging module. The plastic encapsulation may be formed via processes such as mold injection curing, mold compression molding, or adhesive injection curing. In regions of the encapsulation area without components, the plastic encapsulation material primarily enhances the structural stability of the overall packaging. In regions with components, the plastic encapsulation material also seals the components and ensures their sealing stability. In an embodiment, in FIG. 3, at least some components are located outside the hermetic space 35 and are encapsulated by the plastic encapsulation material 36. In some embodiments, the thermal expansion coefficient of the plastic encapsulation material falls within [11×10⁻⁶/deg, 14×10⁻⁶/deg]. The thermal expansion coefficient of the plastic encapsulation material is designed to closely match those of the substrate and barrier structure, minimizing thermal mismatch and preventing warping of the optical chip packaging.

In an embodiment, the optical chip is used for detecting laser beams. The optical chip includes a photoelectric sensor that converts received optical signals into electrical signals. The optical chip packaging module functions as a receiving packaging module, and the optical module incorporating the optical chip packaging module is a receiving module. The circuit structure of the receiving module may vary. As shown in FIG. 6, which illustrates a logical structure of a receiving module, the receiving module includes a circuit board 201, a power supply 202, and an energy storage circuit 203 mounted on the circuit board 201. In some embodiments, the receiving packaging module 204 is mounted on circuit board 205. The receiving packaging module 204 is electrically connected to the energy storage circuit 203. The power supply 202 charges the energy storage circuit 203, which in turn powers the receiving packaging module 204. In some examples, as shown in FIG. 6, the receiving packaging module 204 includes the optical chip 2041 and its driver module 2042. In some embodiments, a signal processing circuit 206 is also integrated on circuit board 205 to process electrical signals output by the receiving packaging module 204.

In an embodiment, the optical chip is configured to emit laser beams. Specifically, the optical chip may serve as an emitting optical chip. In an embodiment, the optical chip includes at least one group of vertical-cavity surface-emitting lasers (VCSELs). The at least one group of VCSELs is mounted onto the carrier board via a Die Attach (DA) process and electrically connected to bonding pads on the carrier board through wire bonding. In some embodiments, each VCSEL may be attached to the carrier board using conductive silver paste. In some embodiments, the VCSELs may be soldered using gold-tin alloys or adhered with DA adhesive. In some embodiments, the VCSELs are arranged in an array on the carrier board, with bonding pads corresponding to each row and column of VCSELs. In embodiments where the optical chip emits laser beams, the optical chip packaging module functions as an emitting packaging module, and the optical module incorporating this module is an emitting module. The circuit structure of the emitting module may vary.

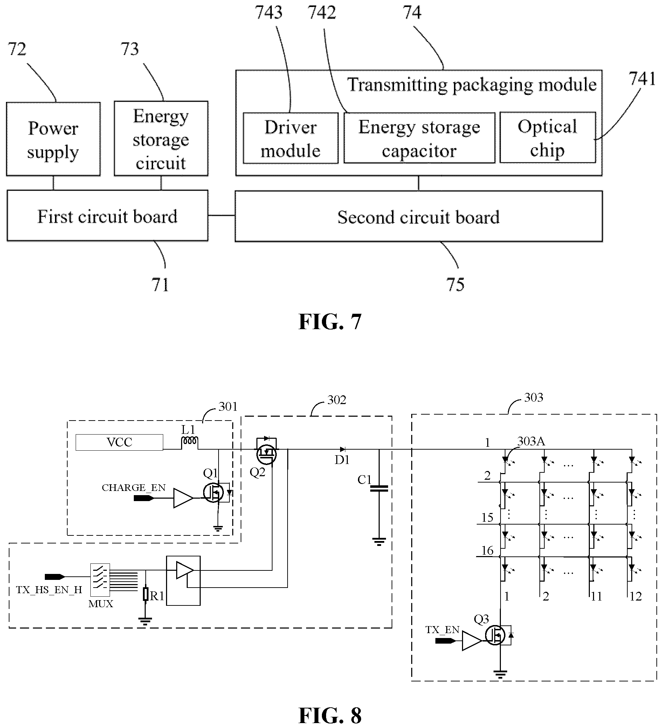

As shown in FIG. 7, which illustrates a logical structure of the emitting module, the emitting module includes a first circuit board 71, a power supply 72, and an energy storage circuit 73 mounted on the first circuit board 71. The emitting packaging module 74 is mounted on a second circuit board 75. The emitting packaging module 74 is electrically connected to the energy storage circuit 73. The power supply 72 charges the energy storage circuit 73, which then powers the emitting packaging module 74. In some embodiments, as shown in FIG. 7, the emitting packaging module 74 includes at least one group of lasers in the optical chip 741. The second circuit board 75 also includes an energy storage capacitor 742 and a driver module 743, where the driver module 743 drives at least a portion of the lasers to emit laser beams using energy stored in the energy storage capacitor 742.

In some embodiments, the emitting packaging module includes an energy transfer circuit and an energy discharge circuit. Energy from the energy storage circuit is transferred to the energy transfer circuit, which then delivers it to the energy discharge circuit, enabling at least one group of lasers to emit laser beams. The driver module includes a high-side driver chip in the energy transfer circuit and a low-side driver chip in the energy discharge circuit. The energy transfer circuit further incorporates an energy storage capacitor within the emitting packaging module, while the energy discharge circuit includes the optical chip. The high-side driver chip transfers energy from the energy storage circuit to the capacitor, and the low-side driver chip drives the release of energy from the capacitor to power the lasers.

In some embodiments, the optical chip includes at least two groups of VCSELs. The energy discharge circuit includes at least a first low-side driver chip, and the energy transfer circuit includes at least a first high-side driver chip. Different groups of VCSELs may emit laser beams simultaneously or at staggered intervals. Each group of VCSELs includes at least one VCSEL, and the VCSELs within the same group may be connected in series or parallel to enable simultaneous or time-division emission of detection laser beams.

The first high-side driver chip and the first low-side driver chip drive at least one selected group of VCSELs from the at least two groups to emit light by gating. In conventional technologies, single-side driving (i.e., using only a high-side driver chip or a low-side driver chip) is typically employed to drive a single group of VCSELs. In the present application, dual-side driving is adopted, meaning that a group of VCSELs can emit laser beams only when driven by both a high-side driver chip and a low-side driver chip. This enhances control flexibility, enabling convenient selection of specific VCSELs from at least two groups for emission in integrated driving systems. Notably, single-side driving remains optional in this application and is not restricted here.

The connection methods among the VCSELs, energy discharge circuit, energy storage capacitors, and energy transfer circuit in the emitting packaging module vary, and one example is described below with reference to FIG. 8. As shown in FIG. 8, which illustrates a circuit topology of an embodiment of the emitting module, each group of VCSELs in this example contains only one VCSEL. In the topology of FIG. 8, the energy storage circuit 301 includes an inductor L1 and a driver switch Q1, the energy transfer circuit 302 includes an energy storage capacitor C1, a diode switch D1, and part of the high-side driver chip (i.e., driver switch Q2), and the energy discharge circuit 303 includes part of the low-side driver chip (i.e., driver switch Q3). The driver switches may be Gallium Nitride (GaN) switches, Metal-Oxide-Semiconductor Field-Effect Transistors (MOSFETs), or Insulated Gate Bipolar Transistors (IGBTs), among others. This application does not restrict the type of driver switches, and in this embodiment, MOSFETs are used as an example.

The power supply VCC is connected to one end of inductor L1, and the other end of L1 is connected to the source terminals of driver switches Q1 and Q2. The gate of driver switch Q1 receives the first pulse control signal, and its drain is grounded. The gate of driver switch Q2 receives the second pulse control signal, and its drain is connected to the anode of diode switch D1. The cathode of diode switch D1 is connected to the positive terminal of energy storage capacitor C2 and the anode of VCSEL 303A. The cathode of VCSEL 303Ais connected to one terminal of driver switch Q3, while the negative terminal of capacitor C2 is grounded. The drain of driver switch Q3 is grounded, and its gate receives the third pulse control signal.

The circuit topology shown in FIG. 8 operates in multiple ways. In an embodiment, VCSEL 303A periodically emits laser beams. Before each emission cycle, driver switches Q2 and Q3 are in the off state. The first pulse control signal activates driver switch Q1, enabling the energy storage circuit path (power supply VCC → inductor L1 → driver switch Q1) to charge inductor L1. After inductor L1 is fully charged, the first pulse control signal turns off the driver switch Q1, and the second pulse control signal activates driver switch Q2, initiating the energy transfer circuit path (inductor L1 → driver switch Q2 → diode switch D1 → energy storage capacitor C1), which transfers energy from inductor L1 to energy storage capacitor C1. Once the transfer is complete, driver switch Q2 turns off, and the third pulse control signal activates driver switch Q3, enabling the energy discharge circuit path (energy storage capacitor C1 → VCSEL 303A → driver switch Q3). This releases the stored energy from energy storage capacitor C1 to VCSEL 303A, causing it to emit laser beams.

The emitting packaging module includes x anode driving modules and y cathode driving modules. The emitting packaging module includes p energy storage capacitors and n groups of VCSELs. The x anode driving modules correspond to the p energy storage capacitors, where p is a positive integer greater than or equal to 1 and less than or equal to n, and x is a positive integer less than or equal to p. Each anode driving module corresponds to at least one energy storage capacitor, and the energy storage capacitors corresponding to each anode driving module are different. The y cathode driving modules correspond to the n groups of VCSELs, where each cathode driving module corresponds to at least one group of VCSELs, and the groups of VCSELs corresponding to each cathode driving module are different. Here, n is a positive integer greater than 1, and y is a positive integer less than or equal to n. Each anode driving module may include a drive switch Q2 and/or a diode switch D1 as shown in FIG. 8, and each cathode driving module may include a drive switch Q3 as shown in FIG. 8. Each high-side driver chip includes at least part of the x anode driving modules, and each low-side driver chip includes at least part of the y cathode driving modules. In an embodiment, the emitting packaging module has only one high-side driver chip and one low-side driver chip, the high-side driver chip contains all x anode driving modules, and the low-side driver chip contains all y cathode driving modules. In another embodiment, the emitting packaging module has two high-side driver chips and two low-side driver chips, one of the two high-side driver chips contains a portion of the x anode driving modules, and the other contains the remaining portion of the x anode driving modules. Similarly, one of the two low-side driver chips contains a portion of the y cathode driving modules, and the other contains the remaining portion of the y cathode driving modules.

The n groups of VCSELs can be configured to emit laser beams simultaneously or in staggered time slots across n sequential emissions. Before each group of VCSELs emits laser beams, the corresponding anode driver module transfers energy from the energy storage circuit to the associated energy storage capacitor, while the corresponding cathode driver module releases the stored energy from the capacitor to drive the selected VCSEL group for emission. In some embodiments, the emitting module may include m power supplies and q energy storage circuits (where m ≤ q and m is a positive integer greater than or equal to 1), corresponding to the p energy storage capacitors and n VCSEL groups in the emitting packaging module. When m < q, each power supply may correspond to no fewer than two energy storage circuits. When q < p, each energy storage circuit may correspond to no fewer than two energy storage capacitors. When p < n, each energy storage capacitor may correspond to no fewer than two VCSEL groups. Prior to the emission of one group of VCSELs, its associated power supply charges the corresponding energy storage circuit, and the energy transfer circuit transfers energy from the storage circuit to the group's dedicated energy storage capacitor.

It should be understood that the voltage values of the m power supplies may be equal or unequal. This application imposes no restrictions on the voltage values of the m power supplies. As an optional embodiment, the m power supplies may drive different quantities of energy transfer circuits. For instance, power supplies corresponding to the central region of the detection field of view may drive fewer groups of energy discharge circuits, while those corresponding to the edge regions may drive more groups of energy transfer circuits. In an embodiment, a central region power supply drives a groups of energy discharge circuits, and an edge region power supply drives b groups of energy transfer circuits, where a≤b. By controlling the voltage values of the m power supplies and the number of energy discharge circuits in the emission array corresponding to each power supply within the detection field of view, the detection requirements can be further matched at the transmitter module level, thereby achieving enhanced flexibility in detection.

As shown in FIG. 8, a single group of VCSELs in the illustrated topology represents one emission channel. FIG. 8 depicts a 4×4 VCSEL array, where each group of VCSELs specifically consists of one VCSEL. Only the circuit loop corresponding to the VCSEL 303A (including the power supply, energy storage circuit, and emitting packaging module) is shown in FIG. 8. For simplicity, the circuit loops for the remaining groups of VCSELs in the 4×4 array are omitted from FIG. 8 but may follow the circuit loop configuration of the VCSEL 303A.

In some embodiments, the at least two groups of VCSELs are arranged as a rectangular VCSEL array, where each group of VCSELs corresponds to an element in the VCSEL array. The first high-side driver chip is configured to drive at least one selected row of elements in the VCSEL array, and the first low-side driver chip is configured to drive at least one selected column of elements in the VCSEL array. Consequently, only the VCSEL group located at the intersection of the row selected by the first high-side driver chip and the column selected by the first low-side driver chip will be successfully driven to emit laser beams. This row-and-column gating mechanism enhances control flexibility for selecting target VCSELs. In some embodiments, the at least two groups of VCSELs can also be arranged in arrays of other shapes, such as circular or elliptical arrays. The driving modules may also independently drive different groups of VCSELs, with no restrictions imposed herein. It should be understood that a single group of VCSELs may include at least one VCSEL. In some embodiments, a group of VCSELs may also include multiple VCSELs, such as 2, 3, 8, or 9 VCSELs. This application imposes no limitations on the number of VCSELs within a single group.

In the above embodiments, by locally encapsulating and modularizing at least two groups of VCSELs along with their driver modules and energy storage capacitors into an emitting packaging module, the pre-packaged module can be mounted onto a circuit board during assembly. Compared with the prior art of directly mounting multiple VCSELs and their driving modules and energy storage capacitors on a circuit board, once a scrapped VCSEL appears, the circuit board of the entire product will be scrapped. The embodiments of the present application can screen the emitting packaging module in advance, thereby achieving higher yield control. The embodiments of the present application also reduce the complexity of the process. In existing products, each VCSEL is often required to be aligned and bonded on the circuit board with high precision. In the embodiments of the present application, the emitting packaging module is formed by pre-packaging, which can reduce the difficulty of packaging each VCSEL on the circuit board. Furthermore, each VCSEL and its energy storage capacitor and driver module are encapsulated in the emitting packaging module, which can reduce the parasitic parameters in the control drive circuit. By integrating and fully encapsulating critical components within the emitting module, this approach ensures consistency and stability across multi-channel emission devices. The sealed structure maintains a stable internal environment, enhancing the reliability of core power devices and driver components, thereby improving the overall reliability of the emitting module. Current automotive-grade reliability requirements are stringent, typically involving WHTOL testing under high-temperature and high-humidity conditions. Unencapsulated bare dies are prone to moisture or impurity infiltration at vulnerable edges or protective layers, which can cause internal short circuits or open failures due to prolonged electromigration. By modularizing VCSELs, driver modules, and capacitors into an emitting packaging module before mounting them onto the circuit board, the emitting module better complies with automotive reliability standards.

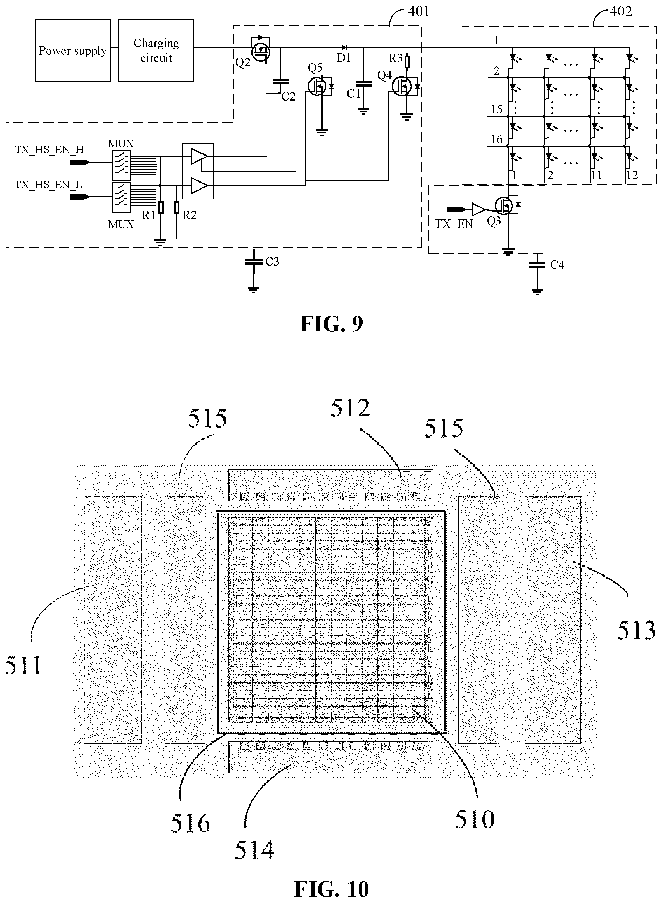

As shown in FIG. 9, which illustrates a circuit topology of another embodiment of the emitting packaging module, the energy transfer circuit 401 additionally includes driver switch Q4 and driver switch Q5. These switches are used to release energy stored in parasitic capacitors on the driver switches after the energy storage capacitor C1 transfers energy to at least one group of VCSELs in the VCSEL array 402.

In some embodiments, the emitting packaging module further includes at least one bootstrap capacitor to activate or maintain the driving state of the first high-side driver chip. In an embodiment, as shown in FIG. 9, the energy transfer circuit 401 includes at least one bootstrap capacitor C2 connected to one terminal of the first high-side driver chip, which activates or sustains the driving state of the connected high-side driver switch. In some embodiments, on the carrier board of the emitting packaging module, the at least one bootstrap capacitor is positioned adjacent to the pins of the first high-side driver chip.

In some embodiments, the emitting packaging module also includes at least one decoupling capacitor corresponding to the at least one high-side driver chip and/or the at least one low-side driver chip. The high-side driver chips and/or low-side driver chips in the emitting packaging module are connected to the power supply negative terminal (or ground) via the decoupling capacitors. For instance, all high-side driver chips may share one decoupling capacitor for connection to ground, while all low-side driver chips share another decoupling capacitor. In some embodiments, both high-side and low-side driver chips may share the same decoupling capacitor. In another configuration, each high-side driver chip uses a separate decoupling capacitor, and each low-side driver chip uses a separate decoupling capacitor. As shown in FIG. 9, all anode driver switches in the energy transfer circuit 401 are connected to the power supply via a first decoupling capacitor C3, while all cathode driver switches in the energy discharge circuit are connected to ground via a second decoupling capacitor C4. Both the first decoupling capacitor C3 and the second decoupling capacitor C4 are located within the hermetic space of the carrier board.

The operating voltages of the high-side driver chips and low-side driver chips are typically fixed at specific values. The power supply is first routed through decoupling capacitors before being delivered to the high-side and low-side driver chips. This prevents parasitic oscillations caused by positive feedback paths through the power supply VCC, thereby eliminating current fluctuations in the power circuit from affecting normal operation. This effectively suppresses parasitic coupling between circuits, ensuring power stability. In some embodiments, the pins of the at least one high-side driver chip and/or the at least one low-side driver chip are positioned adjacent to their corresponding decoupling capacitors.

As shown in FIG. 10, which illustrates an embodiment of component arrangement in the emitting packaging module, at least two groups of VCSELs are arranged in an array. The first high-side driver chip 511 and the first low-side driver chip 512 are positioned around the VCSEL array 510. In some embodiments, the emitting packaging module further includes a second high-side driver chip 513, which, along with the first high-side driver chip 511, is located on opposite sides of the VCSEL array to drive laser emitters in different regions. In an embodiment, as shown in FIG. 10, the driver module includes the first high-side driver chip 511 on the left side of the VCSEL array and the second high-side driver chip 513 on the right side. The VCSEL array is divided into two regions, each driven by the respective high-side driver chip. For instance, the first high-side driver chip 511 drives odd-numbered rows of the VCSEL array 510, while the second high-side driver chip 513 drives even-numbered rows. In some embodiments, the first high-side driver chip 511 controls the upper half of the VCSEL array 510, and the second high-side driver chip 513 controls the lower half. In configurations with a large number of columns, placing high-side driver chips on both sides reduces the distance between the VCSELs and the driver chips, improving response speed and minimizing circuit losses.

In some embodiments, the driver module may include a second low-side driver chip 514 positioned opposite the first low-side driver chip 512 on the other side of the VCSEL array. In an embodiment, as shown in FIG. 10, the first low-side driver chip 512 is located above the VCSEL array 510, while the second low-side driver chip 514 is positioned below. The first low-side driver chip 512 drives VCSEL groups in the right region adjacent to the first high-side driver chip 511, while the second low-side driver chip 514 drives VCSEL groups in the left region adjacent to the second high-side driver chip 513. For arrays with numerous rows, placing low-side driver chips on both sides reduces the distance between the VCSELs and the driver chips, enhancing response speed, minimizing losses, and preventing insufficient laser output power.

A barrier structure 516 is positioned between the VCSEL array 510 and the first high-side driver chip 511, second high-side driver chip 513, first low-side driver chip 512, and second low-side driver chip 514. This barrier structure encloses the optical region where the VCSEL array 510 is located.

Compared to configurations using a single high-side and low-side driver chip, employing two high-side and/or two low-side driver chips enables simultaneous driving of more VCSEL groups. This enhances flexibility in selecting the number of VCSELs to emit laser beams based on detection requirements. In an embodiment, an emitting packaging module may include two high-side driver chips and one low-side driver chip, where the two high-side chips drive different rows of VCSELs, and the single low-side chip drives all columns. In some embodiments, the emitting packaging module may include one high-side driver chip and two low-side driver chips, with the high-side chip driving all rows and the two low-side chips driving different columns.

In some embodiments, as shown in FIG. 10, the emitting packaging module includes an energy storage capacitor array 517 arranged in two columns on both sides of the VCSEL array 510. Barrier structures 515 and 516 are positioned between the two columns of capacitors and the VCSEL array 510 to isolate the capacitor array 517 outside the optical region. In some embodiments, each column of capacitors is located between the VCSEL array 510 and the driver chips. Specifically, each column of capacitors may be positioned between the VCSEL array 510 and the high-side driver chips. Placing the capacitors close to the VCSELs reduces the distance between them, minimizing parasitic parameters in the connecting paths and maximizing energy transfer to the VCSELs.

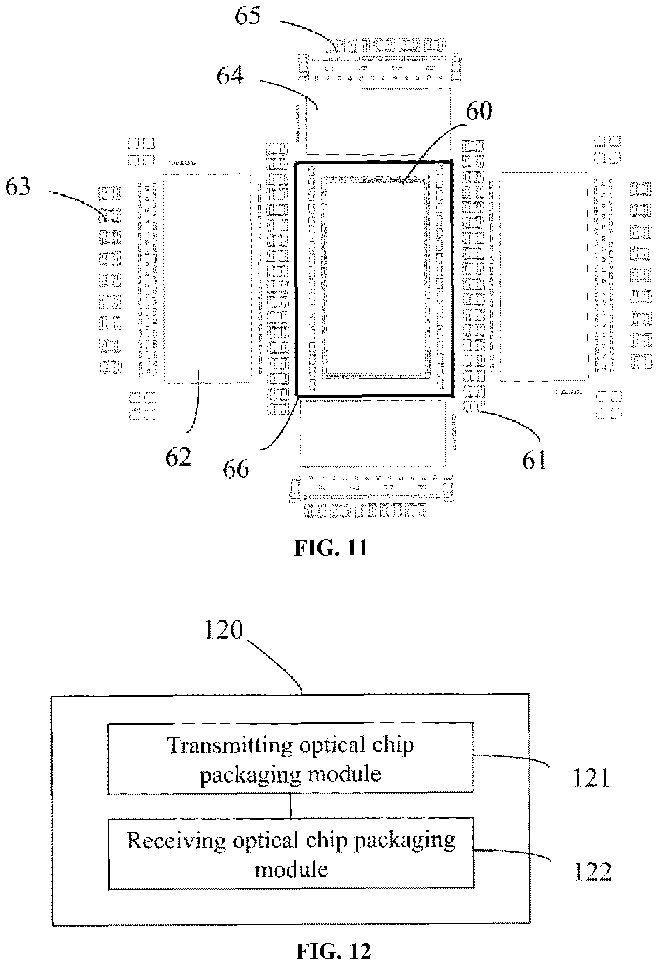

As shown in FIG. 11, which illustrates an embodiment of component arrangement in the emitting packaging module, a barrier structure 66 encloses a rectangular optical region on the carrier board, surrounding the VCSEL array 60. The barrier structure 66 may be a single molded component to ensure hermetic sealing of the optical region. In some embodiments, it may consist of multiple structural components forming a sealed space, with no restrictions on its configuration. Outside the barrier structure 66, two columns of energy storage capacitors 61 are arranged on the left and right sides of the VCSEL array 60.

A low-side driver chip 64 is positioned on each of the upper and lower sides of the VCSEL array 60. The pins of each low-side driver chip 64 are arranged on the side facing away from the VCSEL array 60. Corresponding decoupling capacitors 65 are aligned along the same side, adjacent to the pins of low-side driver chip 64.

On the side of each column of capacitors 61 opposite the VCSEL array 60, a high-side driver chip 62 is placed. The pins of each high-side driver chip 62 are aligned on the side facing away from the capacitors. Bootstrap capacitors 63 are positioned adjacent to these pins. In some embodiments, decoupling capacitors (not shown) for the high-side driver chips 62 are placed on the carrier board's side opposite the VCSEL array 60, adjacent to the driver chip pins.

In FIG. 10 and FIG. 11, the capacitors are shown between the VCSEL arrays and high-side driver chips. In some embodiments, capacitors may also be placed between the VCSEL arrays and low-side driver chips, with no restrictions. In some embodiments, both capacitors and low-side driver chips are located outside the optical region.

In some embodiments, capacitors in the emitting packaging module (e.g., energy storage capacitors, decoupling capacitors, bootstrap capacitors) may be mounted onto the carrier board using Surface Mounted Technology (SMT). In some embodiments, these capacitors may be connected to the corresponding VCSELs via bonding wires.

In some embodiments, high-side driver chips may be pre-packaged using Chip Scale Package (CSP) technology. CSP is a packaging standard where the die-to-package area ratio is approximately 1:1.1. CSP technologies include WLCSP, uBGA, WBGA, TinyBGA, and FBGA. Compared to unpackaged components directly mounted via Chip-On-Board (COB) processes, the wire bonding form requires a large number of bonding, and the integration is poor. In the embodiments of present application, the high-side driver chips are pre-packaged through the WLCSP process, which is conductive to simplifying the process of the overall System-in-Package (SiP) and enhances integration. In some embodiments, high-side driver chips may be pre-packaged into Ball Grid Array (BGA) formats via WLCSP and mounted onto non-optical regions of the carrier board through the solder balls.

In some embodiments, high-side driver chips may be mounted onto non-optical regions of the carrier board by a flip chip process or a SMT process. In above processes, the front side of the high-side driver chip is mounted on the carrier board facing the carrier board. In some embodiments, the high-side driver chip can also be mounted on the carrier board by a COB process and then wire bonded to the pads on the carrier board.

The embodiments of the present application further provide a LiDAR system incorporating the aforementioned optical chip packaging module. In an embodiment, FIG. 12 illustrates a LiDAR 120 comprising the emitting optical chip packaging module 121 for emitting detection laser beams. In some embodiments, the LiDAR 120 may also include a receiving optical chip packaging module 122 for detecting reflected laser beams. The LiDAR 120 may operate as a solid-state LiDAR. In some embodiments, the LiDAR 120 of the present application may also include a scanning device to form a larger range of detection. The scanning device may be a galvanometer, a rotating mirror, or a driving platform. It is understood that the scanning device may be a combination of one or more of the above-mentioned driving devices. For example, the scanning device may be a combination of a galvanometer and a rotating mirror, and optionally the scanning device may also be a galvanometer, or the scanning device may be a rotating mirror, or the scanning device may be a driving platform. The present application does not impose a sole restriction on whether the laser radar includes a scanning device or the specific form of the scanning device. The LiDAR may include only the emitting module, only the receiving module, or both. Additionally, the optical chip packaging module may also apply to infrared detectors, projector light sources, or 3D Time-of-Flight (ToF) modules in smartphones, with no limitations.

The above descriptions of the embodiments are illustrative rather than exhaustive. Many modifications and variations will be apparent to those skilled in the art without departing from the scope and spirit of the disclosed embodiments. The terminology herein is chosen to best explain the principles, practical applications, or market-oriented improvements of the embodiments, or to enable others of ordinary skill in the art to understand the disclosed content.

## Claims

1. An optical chip packaging module, comprising a carrier board and a light-transmitting cover plate mounted on the carrier board, wherein a hermetic space is formed between the carrier board and the light-transmitting cover plate;
an optical chip is fixed on the carrier board in the hermetic space, wherein the carrier board comprises a thermally conductive material in contact with the optical chip, and the thermally conductive material comprises ceramic material and/or metal material.

2. The optical chip packaging module according to claim 1, the carrier board comprises a substrate;
the thermally conductive material is fixed on a surface of the substrate; or
the thermally conductive material is embedded in the substrate.

3. The optical chip packaging module according to claim 2, the thermally conductive material is bonded to the surface of the substrate via a resin adhesive; or
the thermally conductive material is embedded within the substrate via a resin adhesive; or
the thermally conductive material is embedded within the substrate via a soldering process.

4. The optical chip packaging module according to claim 3, the substrate is provided with a through-hole in a region corresponding to the optical chip, and the shape of the thermally conductive material matches a shape of the through-hole for embedding into the through-hole; or
the thermally conductive material comprises: a first portion with a shape matching the shape of the through-hole for embedding into the through-hole, and a second portion extending from one end of the first portion along the surface of the substrate, wherein the second portion abuts a side of the substrate opposite to the optical chip.

5. The optical chip packaging module according to claim 3, the thermally conductive material comprises at least two thermally conductive metal columns,
wherein the at least two thermally conductive metal columns are prefabricated on the substrate at a region connected to at least one group of vertical-cavity surface-emitting lasers through a via process, and penetrate the substrate.

6. The optical chip packaging module according to claim 1, the carrier board comprises at least one layer of aluminum nitride ceramic substrate for stacked setting.

7. The optical chip packaging module according to claim 6, each layer of the ceramic substrate is embedded with at least one metal column.

8. The optical chip packaging module according to claim 7, the at least one metal column comprises an inverted trapezoidal metal column; and/or
the at least one metal column comprises a copper column or a tungsten column.

9. The optical chip packaging module according to any one of claims 1 to 7, wherein the light-transmitting cover plate comprises a metal cover fixed to the carrier board and a light-transmitting component for transmitting laser beams, wherein the light-transmitting component is bonded to the metal cover via a sealing adhesive, wherein:
the metal cover is bonded to the carrier board via a sealing adhesive; or
the substrate is provided with a tin ring, and the metal cover is fixed to the carrier board by welding to the tin ring.

10. The optical chip packaging module according to any one of claims 1 to 7, wherein UV adhesive is coated around the optical chip on the carrier board, the light-transmitting cover plate is cured and adhered to the UV adhesive, and the light-transmitting cover plate, the UV adhesive, and the carrier board collectively form the hermetic space;
at least a portion of the carrier board outside the hermetic space is provided with a plastic encapsulation material to reinforce the optical chip packaging module.

11. The optical chip packaging module according to any one of claims 1 to 7, the carrier board is further fixed with a barrier structure, wherein the light-transmitting cover plate, the barrier structure, and the carrier board collectively form the hermetic space;
the light-transmitting cover plate is sealed and bonded to the barrier structure.

12. An optical module, comprising the optical chip packaging module according to any one of claims 1 to 11 and a circuit board,
wherein the circuit board is provided with a power supply and an energy storage circuit, and the circuit board is electrically connected to the optical chip packaging module.

13. A LiDAR, comprising the optical chip packaging module according to any one of claims 1 to 11.
